# NOUVEAU FASCICULE DE BREVET EUROPEEN

(11) **EP 1 436 895 B2**
(45) Date de publication et mention de la décision concernant l'opposition: **02.04.2014**
(45) Mention de la délivrance du brevet: 27.01.2010
(21) Numéro de dépôt: 02800125.3
(22) Date de dépôt: 26.09.2002
(51) Int. Cl.: H03K 17/955, G08B 13/26

(54) **CAPTEUR DE PRESENCE DESTINE A ETRE INTEGRE DANS UNE POIGNEE D'UN OUVRANT DE VEHICULE AUTOMOBILE**
PRÄSENZSENSOR, DER FÜR DEN EINBAU IN DEN TÜRGRIFF EINES KRAFTFAHRZEUGS AUSGELEGT IST
PRESENCE SENSOR DESIGNED TO BE INCORPORATED IN A MOTOR VEHICLE DOOR HANDLE

(30) Priorité: 27.09.2001 FR 0112455
(43) Date de publication de la demande: 14.07.2004
(73) Titulaire: Valeo Sécurité Habitacle S.A.S., 94042 Créteil cedex (FR)
(72) Inventeur: HUTH, Jean-Claude, F-92160 Anthony (FR); MUSAT, Ciprian, F-94000 Créteil (FR)
(74) Mandataire: Pothmann, Karsten
(86) Numéro de dépôt international: PCT/EP2002/010808
(87) Numéro de publication internationale: WO 2003/030365

(56) Documents cités:
- EP-A2- 0 954 098
- WO-A1-02/33203
- WO-A1-11/40606
- DE-A- 19 537 619
- DE-A1- 3 221 223
- DE-A1- 4 006 119
- DE-A1- 19 617 038
- DE-A1- 19 620 059
- DE-A1- 19 803 642
- US-A- 5 525 843
- US-A- 5 880 538
- US-B1- 6 275 146

## Description

La présente invention concerne un capteur de présence intégré dans une poignée d'un ouvrant d'un véhicule automobile.

On connaît déjà, notamment de la demande de brevet WO 99/19585, un capteur de présence capacitif intégré dans une poignée et comprenant une électrode de mesure pour détecter l'approche d'une main d'utilisateur à son voisinage.

Le document WO 01/40606 décrit un capteur de présence selon le préambule de la revendication 1.

La présente invention vise à proposer une alternative à cette construction.

La présente invention a pour objet un capteur de présence capacitif monté dans une poignée d'un ouvrant d'un véhicule automobile pour surveiller une zone de détection voisine de ladite poignée, ledit capteur comportant une électrode de mesure associée à une électrode de référence, l'électrode de mesure étant positionnée de manière à établir avec l'électrode de référence des lignes de champ traversant la zone de détection, l'électrode de référence est constituée par une plaque électriquement conductrice logée au voisinage de l'électrode de mesure de manière à se trouver à l'intérieur de la poignée lorsque ledit capteur est monté dans la poignée, caractérisé en ce que, l'électrode de mesure s'étend selon un plan perpendiculaire à la plaque conductrice constituant l'électrode de référence et ladite plaque conductrice est décalée par rapport au plan de l'électrode de mesure.

Dans un mode de réalisation particulier de l'invention, la plaque électriquement conductrice est constituée par un circuit imprimé comportant au moins une piste conductrice.

La plaque électriquement conductrice est reliée à une masse pour servir de référence à l'électrode de mesure.

La présente invention concerne en particulier une réalisation du capteur de présence capacitif dans laquelle deux plaques électriquement conductrices sont associées à deux électrodes de mesure, l'une des plaques étant électriquement reliée à la masse du véhicule tandis que l'autre plaque est électriquement reliée à une alimentation à courant continu, les deux plaques étant en outre électriquement reliées par des condensateurs de découplage qui transforment la plaque reliée à l'alimentation en une masse virtuelle, eu égard à la fréquence du signal de mesure délivré aux électrodes de mesure.

Afin de faciliter la compréhension de l'invention, on va en décrire maintenant un mode de réalisation donné à titre d'exemple non limitatif, à l'aide des dessins annexés dans lesquels :
- la figure 1 est une vue en perspective d'une partie d'un capteur de présence selon l'invention,
- la figure 2 représente, en section transversale selon le plan II-II positionné sur la figure 1, l'ensemble du capteur de présence, boîtier plastique et électrodes de mesure compris.

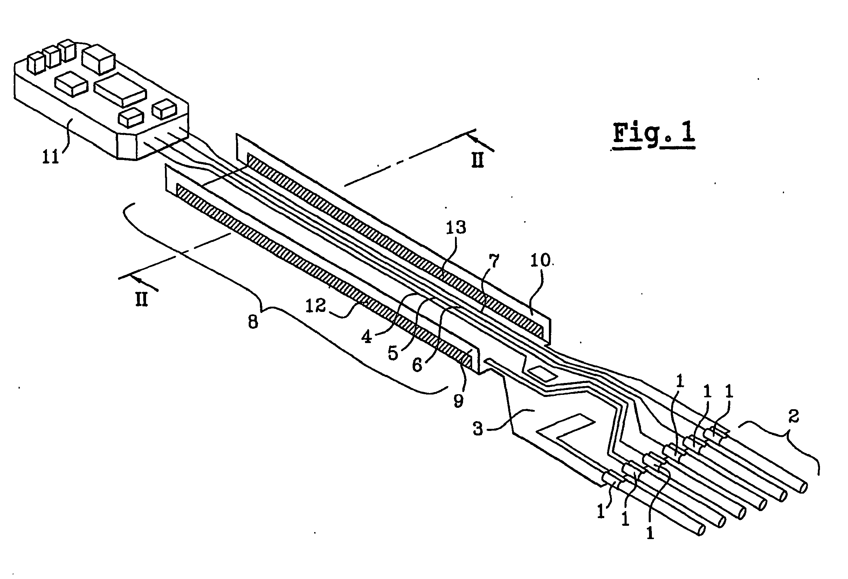

Comme on le voit à la figure 1, les composants intérieurs du capteur de présence sont agencés longitudinalement.

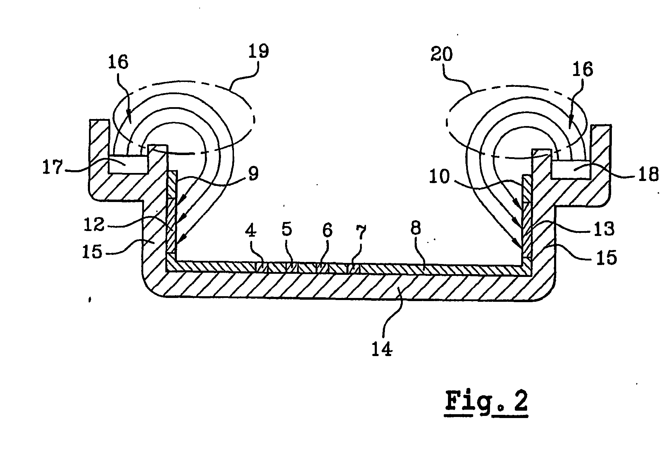

On distingue, de la droite vers la gauche sur la figure 1 :
- des connecteurs électriques 1 pour un faisceau de câbles 2 partiellement représenté
- une plaque flexible de circuit imprimé 3 comportant un certain nombre de pistes conductrices 4-7 et, dans sa région centrale qui s'étend sur presque toute sa longueur, une partie rectangulaire 8 comportant deux bords longitudinaux relevés 9, 10, présentant par conséquent une section en U bien visible sur la figure 2,
- dans le prolongement de la partie rectangulaire 8, un circuit imprimé 11 portant les composants électroniques nécessaires au fonctionnement du capteur de présence et d'un éventuel émetteur récepteur actif.

Les pistes conductrices 4-7 formées sur le circuit imprimé flexible 3 acheminent le courant électrique depuis le faisceau de câbles 2 jusqu'au circuit imprimé 11 portant les composants électroniques.

Parmi ces pistes, les deux latérales 4 et 7 s'étendent jusqu'aux bords relevés 9, 10 du circuit imprimé flexible et couvrent ceux-ci sur toute leur longueur, en formant d'autres pistes 12, 13 constituant l'équivalent de plaques électriquement conductrices.

L'une 12 des pistes est reliée à la source d'alimentation électronique du circuit, l'autre 13 est reliée à la masse du véhicule.

Entre ces deux pistes, des condensateurs de découplage (non identifiés parmi les composants placés sur le circuit imprimé 11) assurent une mise à un même potentiel virtuellement nul, si l'on considère la fréquence de fonctionnement du capteur capacitif qui est de quelques centaines de kiloHertz.

En d'autres termes, les deux pistes conductrices 12, 13 couvrant les bords relevés 9, 10 du circuit imprimé flexible 3 sont reliées toutes deux à une même masse virtuelle.

Les différents éléments représentés à la figure 1 sont disposés dans un boîtier en matière plastique 14 dont une section transversale est représentée à la figure 2.

Ce boîtier 14 présente une forme générale en U qui contient exactement le circuit imprimé flexible 3 précédemment décrit. Il est destiné à s'engager dans une ouverture d'une poignée de portière d'un véhicule, de manière que ladite poignée contienne l'intégralité des éléments portés par ledit boîtier.

Les bords supérieurs 16 des deux branches 15 du U sont elles-même constituées en réceptacles recevant chacun une électrode de mesure 17, 18 sous la forme d'une languette plane qui est reliée, par des moyens non représentés, à une source de courant alternatif dont la fréquence est d'environ 100 à 300 kHz.

Chaque électrode de mesure 17, 18 forme, avec la piste conductrice de masse 12, 13 la plus proche, un condensateur dont les variations de capacité permettent de détecter l'approche d'une main dans la zone de détection 19, 20 associée, délimitée schématiquement en traits mixtes sur la figure 2.

Chaque électrode de mesure 17, 18 s'étend perpendiculairement à la piste conductrice 12, 13 constituant l'électrode de référence 12, 13. En outre, la piste de masse est décalée par rapport au plan de l'électrode de mesure, de sorte que des lignes de champ (représentées par des flèches) traversent la zone de détection 19, 20 correspondante.

Cette zone de détection vise à déceler la présence d'une main d'utilisateur au voisinage de la poignée.

La réalisation des deux plaques de masse en pistes conductrices d'un circuit flexible peut, dans des variantes non représentées, être obtenue soit par des circuits imprimés rigides, soit par des métallisations de surface, ou par l'ajout de plaquettes conductrices collées sur le boîtier en matière plastique ou encore par surmoulage de pistes conductrices sur un support.

Il est bien entendu que le mode de réalisation décrit ci-dessus ne présente aucun caractère limitatif et pourra recevoir toute modification souhaitable sans sortir du cadre de l'invention.

## Revendications

1. Capteur de présence capacitif monté dans une poignée d'un ouvrant d'un véhicule automobile pour surveiller une zone de détection (19, 20) voisine de ladite poignée, ledit capteur comportant une électrode de mesure (17, 18) associée à une électrode de référence (12, 13), l'électrode de mesure étant positionnée de manière à établir avec l'électrode de référence des lignes de champ traversant la zone de détection, l'électrode de référence étant constituée par une plaque électriquement conductrice (9, 12 ; 10, 13) logée au voisinage de l'électrode de mesure de manière à se trouver à l'intérieur de la poignée **caractérisé en ce que** l'électrode de mesure (17, 18) s'étend selon un plan perpendiculaire à la plaque conductrice (12, 13) constituant l'électrode de référence et **en ce que** ladite plaque conductrice est décalée par rapport au plan de l'électrode de mesure,

2. Capteur selon la revendication 1, **caractérisé en ce que** la plaque électriquement conductrice est constituée par un circuit imprimé (3) comportant au moins une piste conductrice (12, 13).

3. Capteur selon la revendication 1 ou 2, **caractérisé en ce que** la plaque électriquement conductrice est reliée à une masse pour servir de référence à l'électrode de mesure.

4. Capteur selon la revendication 1, 2, ou 3, **caractérisé en ce que** deux plaques électriquement conductrices (12, 13) sont associées à deux électrodes de mesure (17, 18), l'une des plaques étant électriquement reliée à la masse du véhicule tandis que l'autre plaque est électriquement reliée à une alimentation à courant continu, les deux plaques étant en outre électriquement reliées par des condensateurs de découplage qui transforment la plaque reliée à l'alimentation en une masse virtuelle, eu égard à la fréquence du signal de mesure délivré aux électrodes de mesure.

## Patentansprüche

1. Kapazitiver Präsenzsensor, der in einen Handgriff einer Tür eines Kraftfahrzeugs montiert ist, um eine dem Handgriff benachbarte Erfassungszone (19, 20) zu überwachen, wobei der Sensor eine Messelektrode (17, 18) aufweist, die einer Bezugselektrode (12, 13) zugeordnet ist, wobei die Messelektrode so positioniert ist, dass sie mit der Bezugselektrode Feldlinien aufbaut, die die Erfassungszone durchqueren, wobei die Bezugselektrode aus einer elektrisch leitenden Platte (9, 12; 10, 13) besteht, die in der Nähe der Messelektrode angeordnet ist, um sich im Inneren des Handgriffs zu befinden, **dadurch gekennzeichnet, dass** die Messelektrode (17, 18) sich gemäß einer Ebene lotrecht zur die Bezugselektrode bildenden leitenden Platte (12, 13) erstreckt, und dass die leitende Platte bezüglich der Ebene der Messelektrode versetzt ist.

2. Sensor nach Anspruch 1, **dadurch gekennzeichnet, dass** die elektrisch leitende Platte aus einer gedruckten Schaltung (3) besteht, die mindestens eine Leiterbahn (12, 13) aufweist.

3. Sensor nach Anspruch 1 oder 2, **dadurch gekennzeichnet, dass** die elektrisch leitende Platte mit einer Masse verbunden ist, um als Bezug für die Messelektrode zu dienen.

4. Sensor nach Anspruch 1, 2 oder 3, **dadurch gekennzeichnet, dass** zwei elektrisch leitende Platten (12, 13) zwei Messelektroden (17, 18) zugeordnet sind, wobei eine der Platten elektrisch mit der Masse des Fahrzeugs verbunden ist, während die andere Platte elektrisch mit einer Gleichstromversorgung verbunden ist, wobei die beiden Platten außerdem elektrisch über Entkopplungskondensatoren verbunden sind, die die mit der Stromversorgung verbundene Platte in eine virtuelle Masse umwandeln, unter Berücksichtigung der Frequenz des an die Messelektroden gelieferten Messsignals.

## Claims

1. Capacitive presence sensor fitted in a handle of an opening of a motor vehicle to monitor a detection area (19, 20) in the vicinity of said handle, said sensor comprising a measuring electrode (17, 18) associated with a reference electrode (12, 13), the measuring electrode being positioned so as to establish with the reference electrode field lines passing through the detection area, the reference electrode consisting of an electrically conductive plate (9, 12; 10, 13) housed in the vicinity of the measuring electrode so as to be located inside the handle, **characterized in that** the measuring electrode (17, 18) extends along a plane perpendicular to the conductive plate (12, 13) forming the reference electrode and **in that** said conductive plate is offset relative to the plane of the measuring electrode.

2. Sensor according to Claim 1, **characterized in that** the electrically conductive plate consists of a printed circuit (3) comprising at least one conductive track (12, 13).

3. Sensor according to Claim 1 or 2, **characterized in that** the electrically conductive plate is connected to a ground to serve as a reference for the measuring electrode.

4. Sensor according to Claim 1, 2 or 3, **characterized in that** two electrically conductive plates (12, 13) are associated with two measuring electrodes (17, 18), one of the plates being electrically linked to the ground of the vehicle whereas the other plate is electrically linked to a direct current power supply, the two plates also being electrically linked by decoupling capacitors that transform the plate linked to the power supply into a virtual ground, given the frequency of the measurement signal delivered to the measuring electrodes.
